# EUROPÄISCHE PATENTSCHRIFT

(11) **EP 1 122 221 B1**
(45) Veröffentlichungstag und Bekanntmachung des Hinweises auf die Patenterteilung: **23.07.2003**
(21) Anmeldenummer: 00810091.9
(22) Anmeldetag: 01.02.2000
(51) Int. Cl.: C03C 17/00, C23C 16/44, C23C 14/22

(54) **Einrichtung zur Oberflächenbehandlung und/oder Beschichtung bzw. zur Fertigung von Bauelementen, insbesondere flacher Bauelemente aus Glas, Glaslegierungen oder Metall, im Durchlaufverfahren**
Apparatus for surface treatment and/or coating, respectively manufacture of building elements, in particular planar building elements made of glass, glass alloys or metal, in a continuous process
Dispositif pour le traitement de surface et/ou le revêtement, respectivement la production d'éléments de construction, en particulier d'éléments de construction plans en verre, alliages vitreuses ou métal, dans un procédé continu

(43) Veröffentlichungstag der Anmeldung: 08.08.2001
(73) Patentinhaber: BÄCHLI, Emil, CH-5304 Endingen (CH)
(72) Erfinder: SAGER-HINTERMANN, Kurt, 5724 Dürrenäsch (CH); BÄCHLI, Emil, 5304 Endingen (CH)
(74) Vertreter: Fenner, Werner, Dipl.-Ing.

(56) Entgegenhaltungen:
- DE-A- 2 833 231

## Beschreibung

Die Erfindung betrifft eine Einrichtung zur Oberflächenbehandlung und/oder Beschichtung bzw. zur Fertigung von Bauelementen, insbesondere flacher Bauelemente aus Glas, Glaslegierungen oder Metall, im Durchlaufverfahren, bestehend aus mehreren in Durchlaufrichtung des Substrates dicht aneinandergereihten, an den Enden Durchtrittsöffnungen aufweisenden Fertigungskammern, die jeweils durch einen ortsfesten Kammerteil und einen von diesem trennbaren Kammerteil gebildet und an eine Vakuumquelle anschliessbar sind, wobei die Fertigungskammem durch metallische Wände begrenzt und die Kammerteile im Randbereich durch gegenüberliegende Dichtungsflächen ausgebildet sind.
Einrichtungen dieser Art werden u.a. von Leybold-Heraeus GmbH in DE-Hanau als sog. Durchlaufanlagen für die Flachglasbeschichtung verwendet und inProspektblättern 14-200.1/2 vom 5.5.82 näher beschrieben. Darin wird einleitend auf den Energieaustausch im Bereich von Fenstern eines Gebäudes hingewiesen. Hierbei sollen in gemässigten und kalten Klimazonen -speziell im Winter- Energiekosten durch Verringerung der Wärmeverluste gespart werden. Dagegen soll in warmen Ländern die Sonnenstrahlentransmission erheblich verringert werden, um die Raumtemperatur niedrig zu halten; auch dafür ist sehr viel Energie erforderlich. Danach werden wärmereflektierende Schichten und die dazu angewandten Beschichtungsverfahren und Beschichtungsanlagen beschrieben.
In einem weiteren Prospekt 14-300.1 der gleichen Firma vom 5.10.83 wird anhand einer Zeichnung auf eine Einrichtung der eingangs genannten Art hingewiesen. Die Einrichtung besteht aus mehreren in einer Durchlaufrichtung des Substrates oder der Glasscheiben von rechts nach links dicht aneinandergereihten Fertigungskammem 3 bis 11, denen eine Wasch-Anlage und Puffer-Station vorgeschaltet sowie eine Puffer-Station und Optische Qualitäts-Kontrolle nachgeschaltet sind. Diese Einrichtung zeichnet sich u.a. durch hohe Wirtschaftlichkeit, Universalität, kurze Taktzeiten, hohen Automatisierungsgrad, hohen Bedienungskomfort, umweltschonende Betriebsweise und hohen Qualitäts-Standard des beschichteten Flachglases aus. Für die vorgestellte Beschichtungsmethode werden horizontale und vertikale Durchlaufverfahren angeboten. Mit diesen lassen sich u.a. farbneutrale Wärmedämmschichten, dekorative, farbige Sonnenschutzschichten und Schichten für Autoglas auftragen.
Einrichtungen dieser Art werden übrigens auch für die Herstellung von Absorbem, der Fotovoltaik und anderen unter Vakuum durchgeführten Herstellverfahren verwendet.
Die veranschaulichten Fertigungskammern, die aufgrund eines hohen Vakuums einer hohen Druckbelastung von aussen ausgesetzt sind, sind mit entsprechend hohem Konstruktionsaufwand ausgestattet. Hierzu sind die auf Gestellen auf dem Boden stehenden unteren Kammerteile, die den Hohlraum einer Fertigungskammer bilden, durch starke seitliche Profilträger und durch an der Unterseite des Bodens quer verlaufende Rippenleisten ausgebildet. Der auf dem unteren Kammerteil aufliegende obere Kammerteil gleicht einem Deckel mit hohem Verrippungsanteil zur Einhaltung der erforderlichen hohen Steifigkeit während der Produktion, der auf einer Rollenbahn durchlaufenden Glasscheiben. Zum Oeffnen der Fertigungskammem sind die oberen Kammerteile mit hochschwenkbaren Armen verbunden. Die einzelnen Fertigungskammern sind für den Transport der Glasscheiben durch schlitzartige Durchtrittsöffnungen verbunden. Am Ein- und Ausschleusende der Einrichtung sind die Oeffnungen für die ein- und austretenden Bauelemente mit betätigbaren Klappen ausgebildet, um das Fluten der Fertigungskammern in Grenzen halten zu können. Zwischen den Kammerteilen und den einzelnen Fertigungskammem sind Dichtungen angeordnet, die zur Aufrechterhaltung des für den Fertigungs- bzw. Beschichtungsprozess erforderlichen Vakuums unerlässlich sind. Zur Funktionsfähigkeit dieser bekannten Einrichtung, die ausschliesslich aus hochwertigem Baustahl mit hohem Gewicht gefertigt ist, ist ein hoher Konstruktionsaufwand notwendig, der eine hohe Steifigkeit und Dichtheit zwischen den Kammerteilen einer Fertigungskammer und zwischen den Fertigungskammern gewährleistet. Nach der umfangreichen Schweissarbeit an den Kammerteilen ist durch den eintretenden Verzug an der Schweisskonstruktion zur Erzielung planer Dichtungsflächen eine spanabhebende Bearbeitung unausweichlich. Diese Bearbeitung kann jedoch nur durch Werkzeugmaschinen ausgeführt werden, die eine grössere Aufspannfläche aufweisen als die Fläche der aufgelegten Kammerteile.

Aufgabe der vorliegenden Erfindung ist es deshalb, eine Einrichtung der eingangs beschriebenen Art zu schaffen, die einen erheblich einfacheren und geringeren Konstruktionsaufwand erfordert.

Erfindungsgemäss wird diese Aufgabe dadurch gelöst, dass die Wände des Hohlraumes einer Fertigungskammer aus jeweils einer an den aus armiertem Beton bestehenden Kammerteilen verankerten metallischen Haut gebildet sind.
Eine Nachbearbeitung der Dichtungsflächen erübrigt sich.
Eine solche Fertigungskammer, die beispielsweise Flachglas mit einer Fläche von 4 x 6m aufzunehmen vermag, wird von bis zu 10⁻⁵ mbar evakuiert, sodass von aussen ein hoher Druck auf die Fertigungskammer einwirkt. Die Haut ist im Hohlraum aus mehreren vakuumdicht verschweissten Wandteilen ausgebildet.

Vorteilhaft ist die metallische Haut an von Beton umgebenen Verankerungselementen, beispielsweise Bolzen oder Schlaudern befestigt. Dabei kann die Armierung beispielsweise aus einem Netz aus Rundstahl bestehen und mit den Verankerungselementen verbunden sein.

Vorzugsweise ist der Hohlraum durch einen wannen- undloder haubenartig geformten Kammerteil gebildet, wobei es sich als einfacher zu erweisen scheint, wenn nur ein Kammerteil den Hohlraum besitzt.

Besonders günstig erweist es sich, wenn wenigstens der stationäre Kammerteil einen Hohlraum aufweist, durch den der davon betroffene Kammerteil schwerer wird als der andere Kammerteil.

Zweckmässig bestehen die Dichtungsflächen der Kammerteile aus der sich in den Dichtungsbereich erstreckenden, die Wände des Hohlraumes bildenden metallischen Haut der Fertigungskammer bzw. die Dichtungsflächen schliessen an die die Wände des Hohlraumes bildende Haut an, wodurch sich die Herstellung der Kammerteile weiter vereinfacht und eine Nachbearbeitung der Dichtungsflächen vermieden werden kann.

Zur Abführung von auftretender Prozesswärme ist vorteilhaft eine den Hohlraum mit der Umgebung verbindende, verschliessbare Leitung vorgesehen.

Vorzugsweise besteht die metallische Haut aus Edelstahl, der im Vakuum eine geringere Ausgasungsrate als Baustahl aufweist, sodass der Energieaufwand beim Evakuieren des geschlossenen Hohlraumes erheblich kleiner ist als bei den bekannten Fertigungskammern. Ueberdies lässt sich eine glatte Edelstahloberfläche leichter reinigen.

Flanschartige Dichtungsflächen mit dazwischenliegenden flachen oder runden Dichtungen aus einem elastischen Werkstoff sind als Dichtungsvorrichtung einfach und besonders geeignet.

Als Vorrichtung zur Herstellung einer erfindungsgemässen Einrichtung erweist sich eine ebene Richtplatte zum Auflegen der metallischen Haut eines Kammerteils beim Verankem der metallischen Haut durch Beschütten mit Beton zur Formgebung des Kammerteils als vorteilhaft, insbesondere wenn zur Herstellung der Richtplatte ein auf einen flachen Boden dicht auflegbarer, mit härtendem Kunstharz ausgiessbarer Rahmen zur Bildung einer ebenen Plattenoberfläche vorgesehen ist. Dadurch kann beispielweise die Herstellung der Fertigungskammem für die erfindungsgemässe Einrichtung an dem Ort vorgenommen werden, wo später mit der Einrichtung die Fertigung der Bauelemente erfolgt. Es erübrigen sich dadurch u.a. auch kostspielige Transporte der Fertigungskammem zur Produktionsstätte.

Vorzugsweise wird zur Herstellung der Einrichtung ein Verfahren angewandt, bei dem die Haut eines Kammerteils innerhalb einer Schalung auf der Richtplatte aufgelegt und anschliessend der schüttfähige Beton zugeführt wird.

Dieses Verfahren kann dadurch vereinfacht werden, wenn die einen Hohlraum bildende Haut eines Kammerteils mit der Dichtungsfläche der Richtplatte zugewandt auf diese aufgelegt wird. Weist ein Kammerteil keinen Hohlraum auf, dann wird die gestreckte Haut als Wandteil der Fertigungskammer auf die Richtplatte aufgelegt.

Bildet die Haut einen Hohlraum eines Kammerteils, dann ist die der Richtplatte zugewandte Wand des Hohlraumes vor der Zuführung von Beton zur Formgebung des Kammerteils auf der Richtplatte abzustützen.

Nachfolgend wird die Erfindung unter Bezugnahme auf die Zeichnung, auf die bezüglich aller in der Beschreibung nicht näher erwähnten Einzelheiten verwiesen wird, anhand eines Ausführungsbeispiels erläutert. In der Zeichnung zeigen:
- Fig. 1: eine Einrichtung zur Oberflächenbehandlung, Beschichtung und/oder Fertigung flacher Bauelemente,
- Fig. 2: einen Querschnitt durch die in Fig. 1 dargestellte Einrichtung,
- Fig. 3: eine Vorrichtung zur Herstellung einer Richtplatte für die Herstellung der in den Fig. 1 und 2 veranschaulichten Einrichtung und
- Fig. 4: eine nach einem in Fig. 3 dargestellten Verfahren hergestellte Richtplatte.

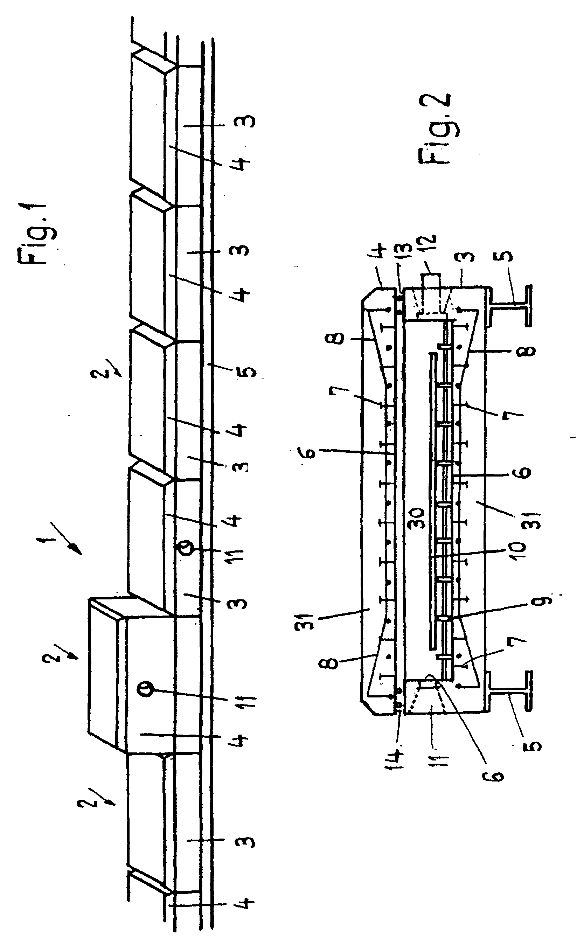

Fig. 1 veranschaulicht eine Einrichtung 1 zur Oberflächenbehandlung und/oder Beschichtung bzw. zur Fertigung flacher Bauelemente, insbesondere aus Glas, Glaslegierungen oder Metall, die in einem Durchlaufverfahren mehrere dicht aneinandergereihte, evakuierbare Fertigungskammern 2 passieren. Die Fertigungskammern 2 weisen jeweils einen ortsfesten (unteren) Kammerteil 3 und einen von diesem abhebbaren (oberen) Kammerteil 4 auf. Letzterer kann -wie bei bekannten Einrichtungen- einseitig schwenkbar am Kammerteil 3 angelenkt oder mittels Kran vom stationären Kammerteil 3 abgehoben werden. Bei der in Fig. 1 gezeigten Ausführung werden die flachen Bauelemente liegend durch die Einrichtung 1 geführt; selbstverständlich könnte bei entsprechender Aufstellung der Einrichtung 1 der Durchlauf der Bauelemente auch stehend erfolgen.

Eine in Fig. 2 im Querschnitt dargestellte Fertigungskammer 2 der Einrichtung 1 liegt mit dem stationären Kammerteil 3 auf zwei parallelen Trägern 5 auf. Der stationäre Kammerteil 3 weist einen nach oben offenen Hohlraum 30 auf, der durch eine aus Blech geformte Edelstahlhaut 6 begrenzt ist. Diese Haut 6 ist mittels Verankerungselementen 7 mit dem aus armiertem Beton 31 geformten Kammerteil 3 verbunden. Die Verankerungselemente werden vorteilhaft durch bekannte Schweissverfahren, beispielsweise mit einem sog. Bolzenschweissapparat mit der Haut 6 verbunden. Die Armierung aus Stahl kann an den Verankerungselementen befestigt werden; sie ist in Fig. 2 mit 8 bezeichnet. Innerhalb des Kammerteils 3 befindet sich eine aus mehreren an quer zur Förderrichtung der Bauelemente sich erstreckenden Wellen befestigte Rollen gebildete Rollenbahn 9, auf der die flachen Bauelemente transportiert und bearbeitet werden. In Durchlaufrichtung der Bauelemente weisen die Kammerteile 3 an ihren Enden schlitzartige Durchtrittsöffnungen 10 auf, die durch Klappen (nicht ersichtlich aber bekannt) verschliessbar sind.
Funktionell besteht zwischen der hier offenbarten Einrichtung 1 bzw. den Fertigungskammern 2 und den bekannten Ausführungen kein wesentlicher Unterschied. Letzterer liegt insbesondere in der Gestalt und Konstruktion einer Fertigungskammer 2.
Es ist jedoch nicht zwingend, den Hohlraum 30 in dem unteren Kammerteil 3 vorzusehen, er könnte auch in dem vom unteren Kammerteil 3 abhebbaren oberen Kammerteil 4 vorgesehen sein.
Weiterhin zeigen die Fig. 1 und 2 ein zur Kontrolle des Hohlraumes 30 oder des darin stattfindenden Prozesses vorgesehenes Schauglas 11 und einen zur Verbindung des Hohlraumes 30 mit einer Vakuumpumpe bestimmten Anschlussstutzen 12. Wie Fig. 2 weiter darstellt, ist der aus armiertem Beton 31 gebildete abhebbare Kammerteil 4 an der dem stationären Kammerteil 3 zugewandten Fläche ebenfalls mit einer auf gleiche Weise verankerten metallischen Haut 6 versehen, die im Randbereich des Kammerteils 4 eine Dichtungsfläche 13 bildet. Diese Dichtungsfläche 13 und die an dem stationären Kammerteil 3 von der diesem zugeordneten Haut 6 gebildeten Dichtungsfläche 14 sind zur Zwischenlage einer endlos umlaufenden flachen Dichtung oder -wie gezeichnet- einer endlos umlaufenden-runden Dichtung 15 vorgesehen.
Um während dem Durchlauf der Bauelemente einzelne Fertigungskammern 2 öffnen zu können, ohne dass dadurch die übrigen Fertigungskammern 2 geflutet werden, sind die Enden der Fertigungskammern 2, insbesondere der die Durchtrittsöffnungen 7 besitzende Kammerteil 3, 4, mit einer betätigbaren resp. steuerbaren Verschlussklappe oder einem -schieber ausgebildet.

In Fig. 2 ist die Möglichkeit einer Schwenkbewegung des Kammerteils 4 beim Abheben von Kammerteil 3 in strichpunktierten Linien angedeutet.
Fig. 1 zeigt bei der Einrichtung 1 eine höhere Fertigungskammer 2 als die übrigen, in der es möglich ist, ein zu behandelndes Bauelement zu wenden und/oder mit einem speziellen Gerät zu bearbeiten.

Die nach dem erfindungsgemässen Konstruktionsprinzip herstellbaren Fertigungskammern 2 gestatten ihre Herstellung an dem Ort, wo sie später zur Behandlung und Bearbeitung der Bauelemente gebraucht werden.

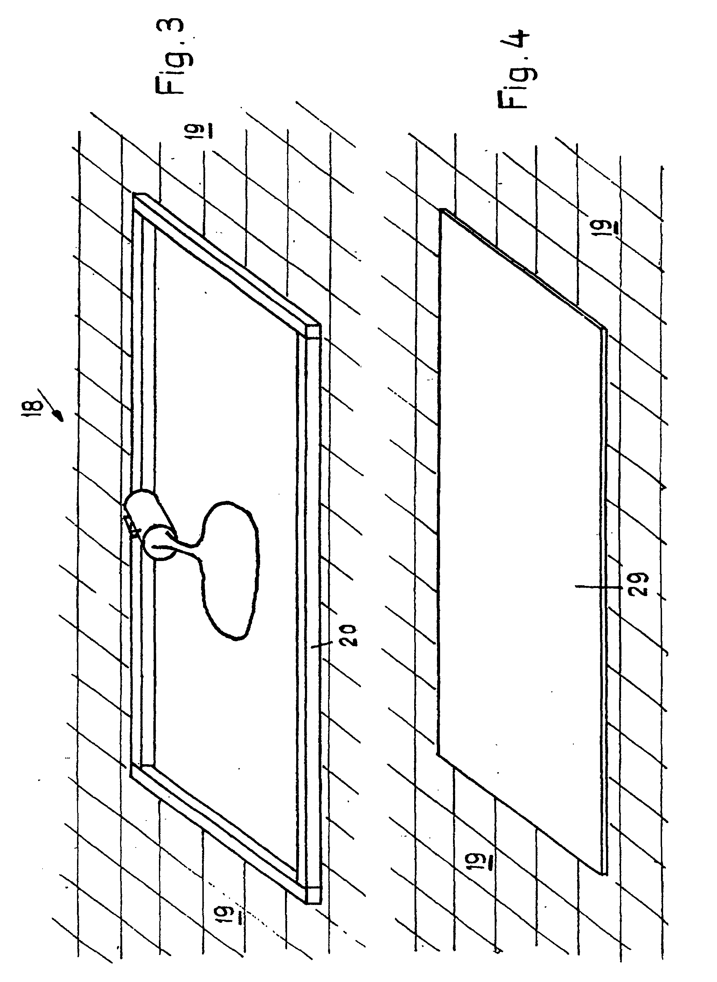

Die Fig. 3 und 4 vermitteln eine Möglichkeit, durch eine besondere Vorrichtung 18 eine Richtplatte 29 herzustellen, mit der die zur absoluten Dichtheit in dem Hohlraum 30 einer Fertigungskammer 2 erforderliche Genauigkeit des Abstandes zwischen den Dichtungsflächen 13, 14 der Kammerteile 3, 4 erzielt werden kann. Hierzu kann auf einen ebenen Boden 19 ein Rahmen 20 mit einer zur Abdichtung gegenüber dem Boden 19 eingelegten Folie (nicht dargestellt) aufgelegt werden. Die lichte Weite des Rahmens 20 ist grösser als die durch die Ausmasse der Kammerteile 3, 4 erforderliche Fläche. In den Rahmen 20 wird ein härtendes Epoxiharz oder dgl. geschüttet, das sich gegen den Rahmen 20 ausdehnt und dabei eine absolut ebene, horizontale Oberfläche bildet. Beim Aushärten des Harzes entsteht eine Richtplatte 29, die nun zum Aufbau einer Schalung (nicht gezeichnet) benutzt werden kann. In die Schalung, die die Grösse der Kammerteile 3, 4 aufweist, wird auf der Richtplatte 29 die flache oder die vorgeformte Haut 6 eines Kammerteils 3, 4 aufgelegt. Bei dem in den Fig. 1 und 2 dargestellten Ausführungsbeispiel endet die mit einem Hohlraum 30 ausgestattete Haut 6 oder die ebene Haut 6 an der Schalung. Die Haut 6, mit den nach oben gerichteten Verankerungselementen 7 und dem Armierungsnetz, wird anschliessend von nachträglich zu verdichtendem Beton 31 überschüttet. Beton 31 bietet aufgrund seines Gewichtes und der Armierung die Gewähr spannungsfreier, ebener Dichtungsflächen 13, 14 an den Kammerteilen 3, 4, sodass ein genauer bzw. gleichmässiger Dichtungsspalt zwischen den Dichtungsflächen 13, 14 entstehen kann.
Bei der einen Hohlraum 30 bildenden Haut 6 ist die der Richtplatte 29 zugewandte Wand des Hohlraumes 30 abzustützen, bevor der Schalung frischer Beton 31 zugeführt wird.

## Patentansprüche

1. Einrichtung zur Oberflächenbehandlung und/oder Beschichtung bzw. zur Fertigung von Bauelementen, insbesondere flacher Bauelemente aus Glas, Glaslegierungen oder Metall, im Durchlaufverfahren, bestehend aus mehreren in Durchlaufrichtung des Substrates dicht aneinandergereihten, an den Enden Durchtrittsöffnungen (10) aufweisenden Fertigungskammern (2), die jeweils durch einen ortsfesten Kammerteil (3) und einen von diesem trennbaren Kammerteil (4) gebildet und an eine Vakuumquelle anschliessbar sind, wobei die Fertigungskammern (2) durch metallische Wände begrenzt und die Kammerteile (3, 4) im Randbereich durch gegenüberliegende Dichtungsflächen (13, 14) ausgebildet sind, **dadurch gekennzeichnet, dass** die Wände des Hohlraumes (30) einer Fertigungskammer (2) aus jeweils einer an den aus armiertem Beton (31) bestehenden Kammerteilen (3, 4) verankerten metallischen Haut (6) gebildet sind.

2. Einrichtung nach Anspruch 1, **dadurch gekennzeichnet, dass** die metallische Haut (6) an von Beton (31) umgebenen Verankerungselementen (7) befestigt ist.

3. Einrichtung nach Anspruch 1 oder 2, **dadurch gekennzeichnet, dass** der Hohlraum (30) durch einen wannen- und/oder haubenartig geformten Kammerteil (3, 4) gebildet ist.

4. Einrichtung nach einem der Ansprüche 1 bis 3, **dadurch gekennzeichnet, dass** wenigstens der stationäre Kammerteil (3, 4) einen Hohlraum (30) aufweist.

5. Einrichtung nach einem der Ansprüche 1 bis 4, **dadurch gekennzeichnet, dass** die Kammerteile (3, 4) an den sich zugewandten Randbereichen flanschartige Dichtungsflächen (13, 14) aufweisen.

6. Einrichtung nach Anspruch 5, **dadurch gekennzeichnet, dass** die Dichtungsflächen (13, 14) durch die den Hohlraum (30) begrenzende metallische Haut (6) gebildet sind.

7. Einrichtung nach einem der Ansprüche 1 bis 6, **dadurch gekennzeichnet, dass** zwischen den Dichtungsflächen (13, 14) der Kammerteile (3, 4) eine Dichtung (15) angeordnet ist.

8. Einrichtung nach einem der Ansprüche 1 bis 8, **dadurch gekennzeichnet, dass** eine den Hohlraum (30) mit der Umgebung verbindende, verschliessbare Leitung vorgesehen.

9. Einrichtung nach einem der Ansprüche 1 bis 8, **dadurch gekennzeichnet, dass** die Haut (6) aus Edelstahl gebildet ist.

10. Einrichtung nach einem der Ansprüche 1 bis 9, **dadurch gekennzeichnet, dass** die an den Enden der Fertigungskammem (2) vorgesehenen Durchtrittsöffnungen (7) die Hohlräume (30) trennende, betätigbare Verschlussklappen (15) oder -schieber aufweisen.

11. Vorrichtung zur Herstellung einer Einrichtung nach einem der Ansprüche 1 bis 10, bestehend aus einer ebenen Richtplatte (29) zum Auflegen der metallischen Haut (6) eines Kammerteils (3, 4) beim Verankern der metallischen Haut (6) durch Beschütten mit Beton (31) zur Formgebung des Kammerteils (3, 4), **dadurch gekennzeichnet, dass** zur Herstellung der Richtplatte (29) ein auf einen flachen Boden dicht auflegbarer, mit härtendem Epoxiharz ausgiessbarer Rahmen zur Bildung einer ebenen Plattenoberfläche vorgesehen ist.

12. Verfahren zur Herstellung der Einrichtung nach einem der Ansprüche 1 bis 11, **dadurch gekennzeichnet, dass** die Haut (6) eines Kammerteils (3, 4) innerhalb einer Schalung auf der Richtplatte (29) aufgelegt und anschliessend der schüttfähige Beton (31) zugeführt wird.

13. Verfahren nach Anspruch 12, **dadurch gekennzeichnet, dass** die einen Hohlraum (30) bildende Haut (6) eines Kammerteils (3, 4) mit der Dichtungsfläche (13) der Richtplatte (29) zugewandt auf diese aufgelegt wird.

14. Verfahren nach Anspruch 13, **dadurch gekennzeichnet, dass** die der Richtplatte zugewandte Wand des Hohlraumes (30) bei der Zuführung von Beton (31) auf der Richtplatte (29) abgestützt ist.

## Claims

1. Arrangement for the surface treatment and/or coating or for the production of components, in particular flat components made of glass, glass alloys or metal, by a continuous process, consisting of a plurality of production chambers (2) arranged closely adjacent to one another in the direction of travel of the substrate and provided at their ends with through openings (10), each formed by a stationary chamber part (3) and a chamber part (4) detachable therefrom and each connectable to a vacuum source, the production chambers (2) being delimited by metallic walls and the chamber parts (3, 4) being formed in their edge regions by opposing sealing surfaces (13, 14), **characterised in that** the walls of the hollow space (30) of a production chamber (2) are each formed by a metallic skin (6) anchored to the chamber parts (3, 4) consisting of reinforced concrete (31).

2. Arrangement according to claim 1, **characterised in that** the metallic skin (6) is fixed to anchoring elements (7) surrounded by concrete (31).

3. Arrangement according to claim 1 or claim 2, **characterised in that** the hollow space (30) is formed by a trough-shaped and/or hood-shaped chamber part (3, 4).

4. Arrangement according to one of claims 1 to 3, **characterised in that** at least the stationary chamber part (3, 4) has a hollow space (30).

5. Arrangement according to one of claims 1 to 4, **characterised in that** the chamber parts (3, 4) are provided at their edge regions facing one another with flange-like sealing surfaces (13, 14).

6. Arrangement according to claim 5, **characterised in that** the sealing surfaces (13, 14) are formed by the metallic skin (6) delimiting the hollow space (30).

7. Arrangement according to one of claims 1 to 6, **characterised in that** a seal (15) is arranged between the sealing surfaces (13, 14) of the chamber parts (3, 4).

8. Arrangement according to one of claims 1 to 8, **characterised by** a closable line connecting the hollow space (30) to the surroundings.

9. Arrangement according to one of claims 1 to 8, **characterised in that** the skin (6) is formed of stainless steel.

10. Arrangement according to one of claims 1 to 9, **characterised in that** the through openings (7) provided at the ends of the production chambers (2) have controllable flaps (15) or shutters separating the hollow spaces (30).

11. Device for the production of an arrangement according to one of claims 1 to 10, consisting of a flat straightening plate (29) on which the metallic skin (6) of a chamber part (3, 4) is placed when the metallic skin (6) is anchored by pouring in concrete (31) in order to form the chamber part (3, 4), **characterised in that** a frame which can be placed snugly on a flat base and filled with a curing epoxy resin is provided in order to form a flat plate surface for the production of the straightening plate (29).

12. Process for the production of the arrangement according to one of claims 1 to 11, **characterised in that** the skin (6) of a chamber part (3, 4) is placed on the straightening plate (29) within a formwork and then the pourable concrete (31) is supplied thereto.

13. Process according to claim 12, **characterised in that** the skin (6) of a chamber part (3, 4) forming a hollow space (30) is placed on the straightening plate (29) with the sealing surface (13) directed towards the straightening plate.

14. Process according to claim 13, **characterised in that** the wall of the hollow space (30) directed towards the straightening plate is supported on the straightening plate (29) as the concrete (31) is supplied.

## Revendications

1. Dispositif pour le traitement de surface et/ou le revêtement, respectivement pour la production d'éléments de construction, en particulier d'éléments de construction plats en verre, en alliages de verre ou en métal, en procédé continu, composé de plusieurs chambres de production (2) présentant aux extrémités des ouvertures de passage (10) et alignées côte à côte hermétiquement dans le sens de déplacement du substrat, lesdites chambres de production (2) étant formées à chaque fois par une partie de chambre fixe (3) et une partie de chambre (4) séparable de celle-ci, étant raccordables à une source de vide, les chambres de production (2) étant délimitées par des parois métalliques et les parties de la chambre (3, 4) étant formées au niveau de leur zone de délimitation par des surfaces d'étanchéité (13, 14) opposées, **caractérisé en ce que** les parois de la cavité (30) d'une chambre de production (2) sont formées chacune d'un revêtement (6) métallique ancré sur les parties de chambre (3, 4) composées de béton armé (31).

2. Dispositif selon la revendication 1, **caractérisé en ce que** le revêtement (6) métallique est fixé sur des éléments d'ancrage (7) entourés de béton (31).

3. Dispositif selon la revendication 1 ou 2, **caractérisé en ce que** la cavité (30) est constituée par une partie de chambre (3, 4) formée en forme de bac et/ou de coupole.

4. Dispositif selon l'une quelconque des revendications 1 à 3, **caractérisé en ce qu'**au moins la partie de chambre (3, 4) fixe présente une cavité (30).

5. Dispositif selon l'une quelconque des revendications 1 à 4, **caractérisé en ce que** les parties de chambre (3, 4) présentent au niveau de leurs zones de délimitation face-à-face des surfaces d'étanchéité (13, 14) de type bride.

6. Dispositif selon la revendication 5, **caractérisé en ce que** les surfaces d'étanchéité (13, 14) sont formées par le revêtement (6) métallique délimitant la cavité (30).

7. Dispositif selon l'une quelconque des revendications 1 à 6, **caractérisé en ce qu'**un joint (15) est placé entre les surfaces d'étanchéité (13, 14) des parties de chambre (3, 4).

8. Dispositif selon l'une quelconque des revendications 1 à 8, **caractérisé en ce qu'**il est prévue une conduite pouvant être fermée, reliant la cavité (30) au milieu extérieur.

9. Dispositif selon l'une quelconque des revendications 1 à 8, **caractérisé en ce que** le revêtement (6) est constitué d'acier inoxydable.

10. Dispositif selon l'une quelconque des revendications 1 à 9, **caractérisé en ce que** les ouvertures de passage (7) prévues aux extrémités des chambres de production (2) présentent des clapets (15) ou des coulisseaux de fermeture actionnables séparant les cavités (30).

11. Dispositif pour la fabrication d'un dispositif selon l'une quelconque des revendications 1 à 10, composé d'une plaque à dresser (29) plate destinée à la pose du revêtement (6) métallique d'une partie de chambre (3, 4) en cas d'ancrage du revêtement (6) métallique par coulage du béton (31) pour le façonnage de la partie de chambre (3, 4), **caractérisé en ce que** pour la fabrication de la plaque à dresser (29), il est prévu un cadre pouvant être posé de manière étanche sur une base plate, dans lequel de la résine époxy durcissante peut être coulée pour former une surface de plaque plane.

12. Procédé pour la fabrication d'un dispositif selon l'une quelconque des revendications 1 à 11, **caractérisé en ce que** le revêtement (6) d'une partie de chambre (3, 4) est posé à l'intérieur d'un coffrage sur la plaque à dresser (29) puis le béton coulable (31) est versé.

13. Procédé selon la revendication 12, **caractérisé en ce que** le revêtement (6) d'une partie de chambre (3, 4) formant une cavité (30) est posé sur la plaque à dresser (29) avec sa surface d'étanchéité (13) tournée vers celle-ci.

14. Procédé selon la revendication 13, **caractérisé en ce que** la paroi de la cavité (30) tournée vers la plaque à dresser est étayée sur la plaque à dresser (29) lors de la coulée du béton (31).
